# EUROPÄISCHE PATENTANMELDUNG

(11) **EP 4 124 868 A1**
(43) Veröffentlichungstag der Anmeldung: **01.02.2023**
(21) Anmeldenummer: 21465539.1
(22) Anmeldetag: 30.07.2021
(51) Int. Cl.: G01R 1/073, G01R 31/28, G01R 31/319, G05B 23/02

(54) **VORRICHTUNG UND VERFAHREN ZUR PRÜFUNG VON ELEKTRISCHEN STEUERGERÄTEN MIT EINEM TRÄGERRAHMEN ZUR AUFNAHME DES ZU PRÜFENDEN STEUERGERÄTS SOWIE EINER ZWISCHENLEITERPLATTE**

(71) Anmelder: Continental Automotive Technologies GmbH, 30165 Hannover (DE)
(72) Erfinder: Dadus, Silviu, 90411 Nürnberg (DE); Maftei, Alexandru, 90411 Nürnberg (DE)
(74) Vertreter: Continental Corporation

(57) **Zusammenfassung**

Die Erfindung beschreibt eine Vorrichtung und ein Verfahren zur Prüfung von elektrischen Steuergeräten (1) mittels einer Vorrichtung mit einem Trägerrahmen (2) zur Aufnahme des zu prüfenden Steuergeräts sowie einer Zwischenleiterplatte (3), wobei die Zwischenleiterplatte (3) einerseits elektrische Steckerkontakte (3.2) zum Anschluss von Prüfmitteln sowie mit diesen über die Zwischenleiterplatte elektrisch verbunden andererseits elastische Federkontakte (3.1) zum elektrischen Kontaktieren von Oberflächenkontakten (1.1) des zu prüfenden Steuergeräts aufweist und das Steuergerät (1) zur Prüfung in Einführrichtung (Z) in den Trägerrahmen (2) eingeführt, dabei auf eine vorgegebene Zielpositionstoleranz positioniert wird, so dass die elastischen Federkontakte (3.1) der Zwischenleiterplatte (3) die entsprechenden Oberflächenkontakte (1.1) des zu prüfenden Steuergeräts (1) kontaktieren und über die elektrischen Steckerkontakte (3.2) die Prüfmittel angeschlossen werden.

## Beschreibung

Die Erfindung betrifft eine Vorrichtung sowie ein Verfahren zur Prüfung von elektrischen Steuergeräten. Steuergeräte sind heutzutage in einer Vielzahl von Funktionen in Kraftfahrzeugen verbaut und werden immer leistungsfähiger. Die darin implementierte Software wird dafür aber auch immer komplexer und damit auch fehleranfälliger, da die Vielzahl von Steuerzuständen und Einflussfaktoren in Realität gar nicht mehr alle durchgeplant und getestet werden können und zunehmend Softwarekomponenten verschiedener Entwickler kombiniert werden und gerade an den Schnittstellen dann bei realen Funktionsabläufen doch unerwartete Systemzustände eintreten können, welche vorab nicht in Betracht gezogen wurden. Andererseits brauchen Automobilhersteller frühzeitig erste Prototypen von Steuergeräten, um deren Zusammenwirken im Gesamtfahrzeug testen zu können, bevor der Hersteller des Steuergerätes sämtliche Funktionstests abgeschlossen hat. Zudem werden auch fortlaufend Updates von Softwarekomponenten bereitgestellt, für die eben auch in einer späteren Produktentwicklungsphase noch solche Funktionstests möglich sein müssen.

Heutzutage sind jedoch Steckkontakte an Steuergeräten immer noch ein nicht unerheblicher Kostenfaktor. Werden Steuergeräte daher bis in die Zeitphase der Serienauslieferung mit Steckkontakten für diese Funktionstests ausgeliefert, sind die Einzelstückkosten entsprechend hoch.

Die Aufgabe der vorliegenden Erfindung ist es, eine geeignete Vorrichtung sowie ein Verfahren zur Prüfung von elektrischen Steuergeräten vorzustellen, bei möglichst lange ein Funktionstest des zu prüfenden Steuergerätes möglich bleibt, die Kosten jedoch reduziert werden. Diese Aufgabe wird durch die Merkmale der unabhängigen Ansprüche gelöst. Vorteilhafte Weiterbildungen der Erfindung ergeben sich aus den Unteransprüchen, wobei auch Kombinationen und Weiterbildungen einzelner Merkmale miteinander denkbar sind.

Ein wesentlicher Gedanke der Erfindung besteht darin, dass die Vorrichtung einen Trägerrahmen zur Aufnahme des zu prüfenden Steuergeräts sowie eine Zwischenleiterplatte aufweist, wobei die Zwischenleiterplatte einerseits elektrische Steckerkontakte zum Anschluss von zumindest einem Prüfmittel sowie mit diesen Steckerkontakten über die Zwischenleiterplatte elektrisch verbunden andererseits elastische Federkontakte zum elektrischen Kontaktieren von Oberflächenkontakten des zu prüfenden Steuergeräts aufweist. Grundsätzlich sind natürlich Oberflächenkontakte auf Steuergeräten und deren Kontaktierung mittels elastischer Federkontakte an sich bekannt, werden jedoch für die Funktionstests am Prüfmittel nicht verbaut, da die heutigen Steuergeräte bzw. die Leiterplatten dieser eine solch hohe Komplexität und kleine Abmaße der Leiterbahn und Oberflächenkontakte aufweisen, dass eine manuelle Kontaktierung mittels Federkontakten an den Prüfmitteln nicht möglich ist.

Durch das Vorsehen eines Trägerrahmens hingegen kann die erforderliche Passgenauigkeit zwischen dem elektrischen Steuergerät und der zwischen Leiterplatte erreicht werden.

Der Trägerrahmen mit der darauf montiertem Zwischenleiterplatte kann für die Funktionsprüfung eine Vielzahl von Steuergeräten eingesetzt werden und reduzieren sich daher die Einzelkosten der zu testenden Steuergeräte erheblich, da die erforderlichen Steckerkontakte nunmehr ausschließlich noch auf der Zwischenleiterplatte vorgehalten werden bzw. zu einem frühen Zeitpunkt nicht mehr auf den Steuergeräten selbst angeordnet werden müssen.

So wird zur Prüfung des elektrischen Steuergeräts dieses zu prüfende Steuergerät vom Trägerrahmen aufgenommen, also beispielsweise in den Trägerrahmen eingeführt bzw. auf den Trägerrahmen entsprechend aufgelegt. Die am Trägerrahmen positionsgenau montierte Zwischenleiterplatte weist einerseits die erforderlichen elektrischen Steckerkontakte zum Anschluss des bzw. der jeweiligen Prüfmittel auf.

Mit diesen Steckerkontakten zu den Prüfmitteln sind andererseits über die Zwischenleiterplatte elektrisch verbunden elastische Federkontakte zum elektrischen Kontaktieren von Oberflächenkontakten des zu prüfenden Steuergeräts vorgesehen.

Das Steuergerät wird zur Prüfung daher in eine vorgegebene Einführrichtung in den Trägerrahmen eingeführt bzw. aufgelegt, wobei das Steuergerät dabei auf eine vorgegebene Zielpositionstoleranz positioniert wird, so dass die elastischen Federkontakte der Zwischenleiterplatte die entsprechenden Oberflächenkontakte des zu prüfenden Steuergeräts kontaktieren und über die elektrischen Steckerkontakte die Prüfmittel angeschlossen werden. Bevorzugte Ausgestaltungen dieser Positionierung wird nachfolgend noch näher beschrieben.

Eine besonders bevorzugte Weiterbildung ergibt sich jedoch noch dadurch, dass als Oberflächenkontakte des Steuergeräts unmittelbar jene SMD-Lötflächen verwendet werden, welche in einer ersten Protypenphase auch direkt mit elektrischen Steckerkontakten zum Anschluss der Prüfmittel verbindbar sind.

Das Layout der Leiterplatte des zu prüfenden Steuergeräts bleibt also in beiden Phasen identisch, sind jedoch für eine zweite Prototypenphase und/oder die Serienproduktion nur noch die die unbestückten Lötflächen über die Vorrichtung und die elastischen Federkontakte weiterhin kontaktierbar und fallen die teuren Steckerkontakte an den zu prüfenden Steuergeräten selbst damit weg und werden ausschließlich noch auf der Zwischenleiterplatte am Trägerrahmen der Vorrichtung montiert, wobei die Vorrichtung natürlich für eine riesige Vielzahl an zu prüfenden Steuergeräten wiederverwendet werden kann.

Heutige Oberflächenkontakte, erst recht heutige SMD-Lötflächen sind jedoch mittlerweile derartig klein, dass eine rein manuelle Kontaktierung mit Federkontakten direkt an den Prüfmitteln, beispielsweise als Anschlussklemmen oder dergleichen überhaupt nicht mehr vorstellbar ist. Die Oberflächenkontakte haben Abstände von unter 1 mm zueinander und müssen natürlich das zu prüfende Steuergerät und die Federkontakte zueinander entsprechen positionsgenau ausgerichtet werden. Daher ist vorzugsweise am Trägerrahmen zumindest eine erste Positionierhilfe vorgesehen, an welcher das zu prüfende Steuergerät von einer Startpositionstoleranz zu einer demgegenüber engeren ersten Zielpositionstoleranz geführt wird.

Zusätzlich ist in einer weiteren Ausgestaltung auf der Zwischenleiterplatte zumindest eine weitere Positionierhilfe vorgesehen, die in Einführrichtung des Steuergeräts Vorzugsweise erst dann erreicht wird, wenn über die erste Positionierhilfe die engere erste Zielpositionstoleranz erreicht wurde und dann durch die zweite Positionierhilfe eine gegenüber der ersten noch engere zweite Zielpositionstoleranz erreicht wird.

Die erste Positionierhilfe ist in einem nachfolgend noch näher beschriebenen Ausführungsbeispiel eine Öffnung im Trägerrahmen zur Aufnahme des Steckerkragens des Steuergeräts und weist diese Öffnung in Einführrichtung des Steuergeräts eine sich verengende Öffnungsbreite auf.

Die zweite Positionierhilfe sind in diesem Ausführungsbeispiel zumindest zwei Positionierungszapfen auf der Zwischenleiterplatte, welche über die Federkontakte hinausstehen und in Öffnungen auf der Leiterplatte des zu prüfenden Steuergeräts eingeführt werden.

Das Ausführungsbeispiel wird nachfolgend anhand der Figuren noch näher erläutert, wobei identische Bauelemente in den verschiedenen Figuren identisch bezeichnet wurden, gerade bei mehrfach oder in einer Vielzahl auf dem Steuergerät vorhandene Elemente jedoch jeweils nur einzelne entsprechend beschriftet wurden. Es zeigen:
- Fig. 1: Explosionszeichnung eines Ausführungsbeispiels
- Fig. 2: Vorrichtung bestehend aus Trägerrahmen mit montierter Zwischenleiterplatte
- Fig. 3: Ansichten der Zwischenleiterplatte
- Fig.4: Schnitt durch den Verbindungsbereich von Zwischenleiterplatte, Federkontakten und der aufliegenden Leiterplatte des zu prüfenden Steuergeräts
- Fig. 5: Ausschnitt der Leiterplatte des zu prüfenden Steuergeräts mit den auch als Oberflächenkontakte verwendeten SMD-Lötflächen
- Fig.6: Skizzierung des Einführens des Steuergeräts in den Trägerrahmen

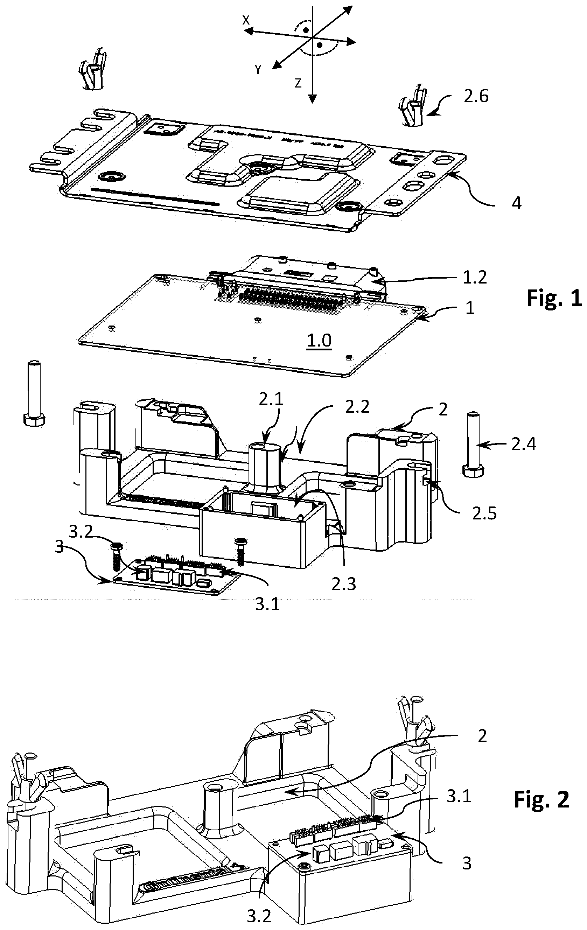

Die Figur 1 zeigt die Vorrichtung zur Prüfung eines elektrischen Steuergeräts (1), wobei die Vorrichtung einen Trägerrahmen (2) zur Aufnahme des zu prüfenden Steuergeräts (1) sowie eine Zwischenleiterplatte (3) aufweist. Die Zwischenleiterplatte (3) weist einerseits elektrische Steckerkontakte (3.2) zum Anschluss von Prüfmitteln sowie mit diesen Steckerkontakten (3.2) über die Zwischenleiterplatte (3) bzw. nicht näher in den Figuren dargestellte Leiterbahnen auf bzw. in der Zwischenleiterplatte elektrisch verbunden andererseits elastische Federkontakte (3.1) zum elektrischen Kontaktieren von Oberflächenkontakten (1.1) des zu prüfenden Steuergeräts (1) auf. Als Federkontakte (3.1) sind hier sogenannte Pogo-Pins in mehreren Gruppen mit jeweiligen Führungshaltern vorgesehen. In einem Führungshalter sind jeweils in einer Führungsöffnung jeweils ein Pin vorgesehen, welcher eine Spitze aufweist, welche in Einführrichtung der Leiterplatte durch eine Feder rückfedernd gelagert ist und deren anderes Ende in der Zwischenleiterplatte elektrisch leitend verbunden eingepresst oder ein gelötet ist. Durch die Führungshalter können die Federkontakte 3.1 besonders positionsgenau auf die entsprechenden Oberflächenkontakte der Leiterplatte positioniert werden. Grundsätzlich könnten aber auch andere Federkontakte, beispielsweise entsprechende Blattfederelemente oder dergleichen verwendet werden.

Figur 1 zeigt darüber hinaus den Aufnahmebereich 2.3 für die Zwischenleiterplatte 3 innerhalb des Trägerrahmens 2 sowie am Trägerrahmen 2 eine Mehrzahl vor definierter Auflagepunkte 2.1 für die Leiterplatte 1.0 des Steuergeräts 1. Darüber hinaus ist vorzugsweise eine Fixierung des Steuergerätes 1 im Trägerrahmen 2 während des Funktionstests vorgesehen, in dem das Steuergerät bzw. in diesem Ausführungsbeispiel vorzugsweise dieses über den Haltedeckel 4 durch Befestigungsstifte 2.4 und Flügelmuttern 2.6 verschraubt wird. Vorzugsweise sind die Befestigungsstifte 2.4 in entsprechenden Ausnehmungen 2.5 des Trägerrahmens 2 angeordnet.

Figur 2 zeigt die Vorrichtung mit Trägerrahmen 2 und montierter Zwischenleiterplatte 3.

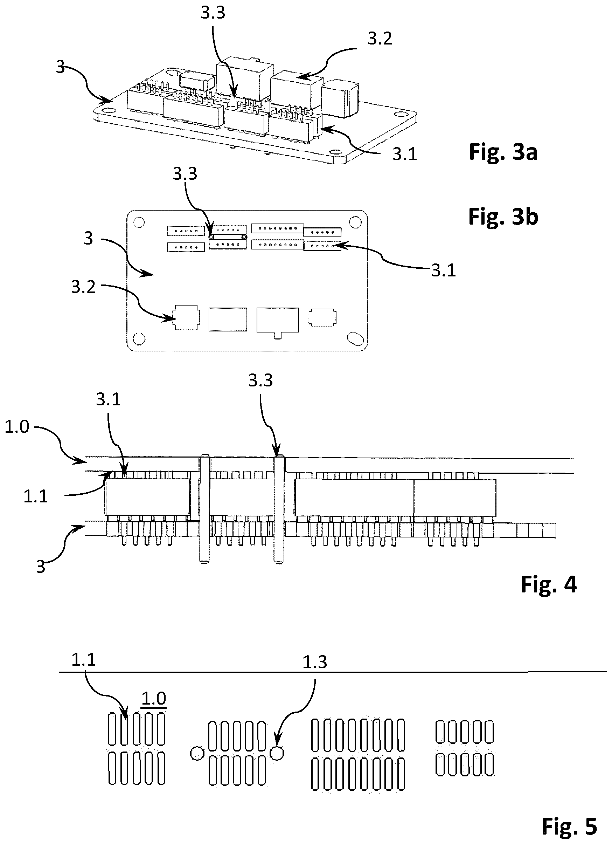

Die Figuren 3A und 3B zeigen nun nochmals im Detail die Zwischenleiterplatte 3 mit den Gruppen von Federkontakten 3.1 und deren Führungshaltern sowie die Steckkontakte 3.2 zum Anschluss der Prüfmittel. Darüber hinaus ist bereits mit 3.3 die zweite Positionierhilfe aus hier zwei Positionierungszapfen auf der Zwischenleiterplatte (3) zu erkennen, welche über die Federkontakte (3.1) hinausstehen und in Öffnungen (1.3) auf der Leiterplatte (1.0) des zu prüfenden Steuergeräts (1) eingeführt werden, wie in der Schnittdarstellung in Fig. 4 besonders gut zu erkennen. Zudem zeigt Figur 4 die in der Zwischenleiterplatte 3 befestigten Federkontakte 3.1 sowie das Anliegen dieser gegenüberliegend auf den Oberflächenkontakten 1.1 der Leiterplatte 1.0 des Steuergeräts 1.

Die Fig. 5 zeigt nun noch in einer Detaildarstellung die Oberfläche der Leiterplatte 1.0 mit den hier als SMD-Lötflächen ausgestalteten Oberflächenkontakten 1.1 sowie die Bohrungen 1.3 für das Einführen der Positionierungszapfen 3.3. Es werden also vorzugsweise als Oberflächenkontakte (1.1) des Steuergeräts SMD-Lötflächen verwendet werden, welche in einer ersten Protypenphase auch direkt mit elektrischen Steckerkontakten zum Anschluss der Prüfmittel verbindbar sind.

So kann das Layout der Leiterplatte 1.0 unverändert bleiben, für die 1. Prototypenphase die Oberflächenkontakte 1.0 noch herkömmlich direkt mit entsprechenden Steckerkontakten bestückt werden, jedoch für eine zweite Prototypenphase und/oder die Serienproduktion die unbestückten Lötflächen (1.1) über die Vorrichtung und die elastischen Federkontakte (3.1) kontaktierbar bleiben. Dadurch reduzieren sich die Kosten des Steuergeräts in diesen späteren Phasen erheblich und wird zudem ein Redesign der Leiterplatte ebenfalls eingespart, bleiben die Steuergeräte jedoch weiterhin testbar. Selbst verständlich kann neben dem Funktionstest auch ein Update der Steuerungssoftware oder weitere Zusatzfunktionen mit über diese elektrische Kontaktierung ermöglicht werden.

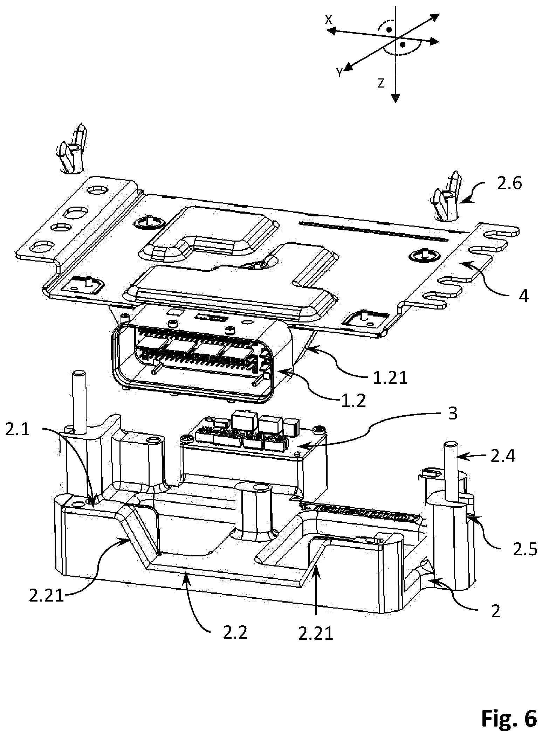

Die Figur 6 soll zur Veranschaulichung des mehrstufigen Positionierungsprozesses genutzt werden und zeigt am Trägerrahmen (2) eine erste Positionierhilfe (2.2), an welcher das zu prüfende Steuergerät (1) von einer Startpositionstoleranz zu einer demgegenüber engeren Zielpositionstoleranz geführt wird. Die erste Positionierhilfe ist dabei eine Öffnung (2.2) im Trägerrahmen 2 zur Aufnahme des Steckerkragens (1.2) des Steuergeräts 1. Diese Öffnung (2.2) weist aufgrund der Einführschräge 2.21 in Einführrichtung (Z) des Steuergeräts eine sich verengende Öffnungsbreite auf, welche vorzugsweise mit einer Einführschräge 1.21 am Steckerkragens 1.2 des Steuergeräts zusammen wirkt und so beim Zusammenführen in Fügerichtung Z das Steuergerät 1 zumindest in X-Richtung, vorzugsweise außerdem auch in Y-Richtung positioniert wird.

Wie bereits in Bezug auf die Figuren 3-5 erläutert, ist zusätzlich auf der Zwischenleiterplatte (3) zumindest die weitere Positionierhilfe (3.3) vorgesehen, wobei diese in Einführrichtung (Z) des Steuergeräts erst dann erreicht wird, wenn über die erste Positionierhilfe (2.2) eine erste engere Zielpositionstoleranz erreicht wurde und dann durch die zweite Positionierhilfe eine gegenüber der ersten noch engere zweite Zielpositionstoleranz erreicht wird.

### Bezugszeichenliste:

- 1: zu prüfendes Steuergerät
- 1.0: Leiterplatte des zu prüfenden Steuergeräts
- 1.1: Oberflächenkontakte auf der Leiterplatte des zu prüfenden Steuergeräts
- 1.2: Steckerkragen am zu prüfenden Steuergerät
- 1.21: Einführschräge am Steckerkragens
- 1.3: Positionierungsbohrungen in der Leiterplatte des zu prüfenden Steuergeräts
- 2: Trägerrahmen
- 2.1: Auflagepunkte am Trägerrahmen für das Steuergerät
- 2.2: Öffnung im Trägerkragen zur Einführung des Steckerkragens
- 2.21: Einführschräge an der Öffnung 2.2
- 2.3: Aufnahme für die Zwischenleiterplatte am Trägerrahmen
- 2.4: Befestigungsstifte zwischen Trägerrahmen und zu prüfendem Steuergerät
- 2.5: Öffnung zur Aufnahme der Befestigungsstifte
- 2.6: Flügelmuttern zum Fixieren des Steuergeräts während des Tests im Trägerrahmen
- 3: Zwischenleiterplatte
- 3.1: Federkontakte auf der Zwischenleiterplatte
- 3.2: Steckerkontakte auf der Zwischenleiterplatte zum Anschluss der Prüfmittel
- 3.3: Positionierungszapfen auf der Zwischenleiterplatte
- 4: Haltedeckel des Steuergeräts

## Patentansprüche

1. Vorrichtung zur Prüfung von elektrischen Steuergeräten (1), wobei die Vorrichtung einen Trägerrahmen (2) zur Aufnahme des zu prüfenden Steuergeräts (1) sowie eine Zwischenleiterplatte (3) aufweist, wobei die Zwischenleiterplatte (3) einerseits elektrische Steckerkontakte (3.2) zum Anschluss von Prüfmitteln sowie mit diesen über die Zwischenleiterplatte (3) elektrisch verbunden andererseits elastische Federkontakte (3.1) zum elektrischen Kontaktieren von Oberflächenkontakten (1.1) des zu prüfenden Steuergeräts (1) aufweist.

2. Vorrichtung nach Anspruch 1, wobei am Trägerrahmen (2) zumindest eine erste Positionierhilfe (2.2) aufweist, an welcher das zu prüfende Steuergerät (1) von einer Startpositionstoleranz zu einer demgegenüber engeren Zielpositionstoleranz geführt wird.

3. Vorrichtung nach Anspruch 2, wobei zusätzlich auf der Zwischenleiterplatte (3) zumindest eine weitere Positionierhilfe (3.3) vorgesehen ist, die in Einführrichtung (Z) des Steuergeräts erst dann erreicht wird, wenn über die erste Positionierhilfe (2.2) eine erste engere Zielpositionstoleranz erreicht wurde und dann durch die zweite Positionierhilfe eine gegenüber der ersten noch engere zweite Zielpositionstoleranz erreicht wird.

4. Vorrichtung nach Anspruch 2, wobei die erste Positionierhilfe eine Öffnung (2.2) im Trägerrahmen zur Aufnahme des Steckerkragens (1.2) des Steuergeräts ist und diese Öffnung (2.2) in Einführrichtung des Steuergeräts eine sich verengende Öffnungsbreite aufweist.

5. Vorrichtung nach Anspruch 3, wobei die zweite Positionierhilfe zumindest zwei Positionierungszapfen (3.3) auf der Zwischenleiterplatte (3) sind, welche über die Federkontakte (3.1) hinausstehen und in Öffnungen (1.3) auf der Leiterplatte (1.0) des zu prüfenden Steuergeräts (1) eingeführt werden.

6. Verfahren zur Prüfung von elektrischen Steuergeräten (1) mittels einer Vorrichtung mit einem Trägerrahmen (2) zur Aufnahme des zu prüfenden Steuergeräts sowie einer Zwischenleiterplatte (3), wobei die Zwischenleiterplatte (3) einerseits elektrische Steckerkontakte (3.2) zum Anschluss von Prüfmitteln sowie mit diesen über die Zwischenleiterplatte elektrisch verbunden andererseits elastische Federkontakte (3.1) zum elektrischen Kontaktieren von Oberflächenkontakten (1.1) des zu prüfenden Steuergeräts aufweist und das Steuergerät (1) zur Prüfung in Einführrichtung (Z) in den Trägerrahmen (2) eingeführt, dabei auf eine vorgegebene Zielpositionstoleranz positioniert wird, so dass die elastischen Federkontakte (3.1) der Zwischenleiterplatte (3) die entsprechenden Oberflächenkontakte (1.1) des zu prüfenden Steuergeräts (1) kontaktieren und über die elektrischen Steckerkontakte (3.2) die Prüfmittel angeschlossen werden.

7. Verfahren nach Anspruch 6, wobei als Oberflächenkontakte (1.1) des Steuergeräts SMD-Lötflächen verwendet werden, welche in einer ersten Protypenphase auch direkt mit elektrischen Steckerkontakten zum Anschluss der Prüfmittel verbindbar sind, jedoch für eine zweite Prototypenphase und/oder die Serienproduktion die unbestückten Lötflächen (1.1) über die Vorrichtung und die elastischen Federkontakte (3.1) kontaktierbar sind.
